# EUROPEAN PATENT APPLICATION

(11) **EP 2 063 692 A2**
(43) Date of publication of application: **27.05.2009**
(21) Application number: 08168330.2
(22) Date of filing: 05.11.2008
(51) Int. Cl.: H05K 3/40

(54) **Method of forming conductive bumps**

(30) Priority: 20.11.2007 JP 2007300149
(71) Applicant: SHINKO ELECTRIC INDUSTRIES CO., LTD., Nagano-shi, Nagano 381-2287 (JP)
(72) Inventor: Sakaguchi, Hideaki, Nagano 381-2287 (JP); Higashi, Mitsutoshi, Nagano 381-2287 (JP)
(74) Representative: Fenlon, Christine Lesley

(57) **Abstract**

A method of forming a conductive bump of the present invention, includes the steps of, preparing a substrate (1) including a connection pad (C1) and a protection insulating layer (18), in which an opening portion (18a) is provided on the connection pad (C1), on a surface layer side, arranging a first conductive ball (30), at least an outer surface portion of which is made of solder, on the connection pad (C1) in the opening portion (18a) of the protection insulating layer (18), filling a solder layer (32) in the opening portion (18a) by applying a reflow heating to the first conductive ball(30), arranging a second conductive ball (50) on the solder layer (32), and obtaining conductive bump (B) which protrudes from an upper surface of the protection insulating layer (18), by joining the solder layer (32) and the second conductive ball (50) by a reflow heating.

## Description

### BACKGROUND OF THE INVENTION

### 1. Field of the Invention

The present invention relates to a method of forming conductive bumps and, more particularly, a method of forming conductive bumps acting as connection terminals of a wiring substrate onto which a semiconductor chip is flip-chip mounted, or an element built-in silicon wafer, or the like.

### 2. Description of the Related Art

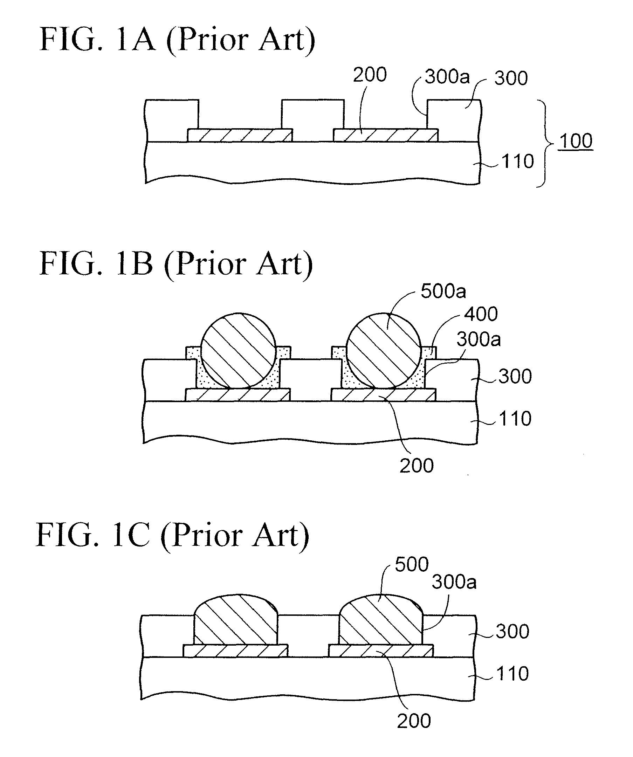

In the prior art, there is a wiring substrate that is equipped with solder bumps on which a semiconductor chip is flip-chip mounted. In the method of forming the solder bumps on the wiring substrate in the prior art, as shown in FIG.1A, first, a wiring substrate 100 on which the solder bumps are to be formed is prepared. In the wiring substrate 100, connection pads 200 connected to the build-up wiring (not shown) are formed on an interlayer insulating layer 110, and a solder resist 300 in which opening portions 300a are provided on the connection pads 200 respectively is formed.

Then, as shown in FIG.1B, a flux 400 is coated on the connection pads 200. Then, a solder ball 500a whose diameter corresponds to the opening portion 300a in the solder resist 300 is arranged on the connection pads 200 respectively. At this time, the solder balls 500a are arranged to project from an upper surface of the solder resist 300.

Then, as shown in FIG.1C, the solder balls 500a are melted by applying the reflow heating to them, and joined to the connection pads 200. Then, a flux residue is removed. Accordingly, solder bumps 500 that project from the upper surface of the solder resist 300 are obtained.

As the technology related to the above, in Patent Literature 1 (Patent Application Publication (KOKAI) Hei 9-51050), it is set forth that a brazing paste (solder) is filled on the connection pads provided on inner surfaces of the recess portions in the insulating substrate, then the ball-like terminals are arranged thereon, and then the heating is applied to melt the brazing paste and the ball-like terminals integrally and also join them to the connection pads by the brazing.

Also, in Patent Literature 2 (Patent Application Publication (KOKAI) Hei 9-107045), it is set forth that the solder paste is printed on respective electrodes of the package, the ball is arranged on respective electrodes through the mask, and then respective balls are soldered to the electrodes by heating the package.

Also, in Patent Literature 3 (Patent Application Publication (KOKAI) Hei 11-54557), it is set forth that, in the semiconductor device in which one chip electrodes and the other substrate are electrically connected mutually, the chip electrodes and the substrate are electrically connected to each other via two minute balls that are inserted between one chip electrodes and the other substrate.

Recently, a narrower pitch (e.g., 100 µm or less) between the connection pads of the wiring substrate is advancing with enhancing performance of the semiconductor chip. Also, in order to get enough reliability of the connection to the semiconductor chip, a height of the solder bumps in excess of 30 µm must be ensured from an upper surface of the solder resist in the wiring substrate.

In the method of forming the solder bumps using the above solder balls (FIGS.1A to 1C), in order to join the solder bumps 500 to the connection pads 200 stably and prevent a short circuit between adjacent solder bumps 500, a diameter of the solder ball 500a must be set equal to or smaller than a diameter of the opening portions 300a of the solder resist 300.

For example, when a diameter of the opening portions 300a of the solder resist 300 is 50 µm and a height of the same is 20 µm, merely the solder ball 500a having a diameter of 50 µm at a maximum can be arranged thereon. In this case, the solder ball 500a is arranged on the connection pad in a state that such solder ball is protruded by 30 µm from an upper surface of the solder resist 300. However, when the reflow heating is applied to the solder ball 500a subsequently, the solder ball 500a is melted to rise from the upper surface of the solder resist 300 by about 20 µm. As a result, a resultant height of the solder bump 500 becomes lower than a height in the designed specification.

In this manner, in the method of forming the solder bumps using the solder balls in the prior art, when a reduction of the pitch between the connection pads is proceeding, it is difficult to ensure sufficiently a height of the solder bump. Thus, such a problems exists that the above method cannot easily respond to the mounting of the high-performance semiconductor chip. For this reason, the method of increasing a height of the solder bump from the solder resist by reducing a thickness of the solder resist is considered. But a problem of reliability arises and thus this method cannot also easily respond to the mounting of the high-performance semiconductor chip.

Also, in above Patent Literatures 1 and 2, because the solder balls are mounted on the solder paste, it is possible to ensure a height of the bump to some extent. However, when the solder paste is applied, sometimes voids may be produced in applying the reflow heating. In particular, it is feared that, specially when a pitch between the connection pads is narrowed, sufficient yield cannot be attained.

### SUMMARY OF THE INVENTION

It is desirable to provide a method of forming conductive bumps, capable of forming conductive bumps of enough height on connection pads in opening portions in a protection insulating layer (a solder resist) with good reliability even when a pitch between connection pads of a wiring substrate, or the like is narrowed.

According to an embodiment of the present invention there is provided a method of forming a conductive bump, which includes the steps of, preparing a substrate including a connection pad and a protection insulating layer, in which an opening portion is provided on the connection pad, on a surface layer side, arranging a first conductive ball, at least an outer surface portion of which is made of solder, on the connection pad in the opening portion of the protection insulating layer, filling a solder layer in the opening portion by applying a reflow heating to the first conductive ball, arranging a second conductive ball on the solder layer, and obtaining a conductive bump which protrudes from an upper surface of the protection insulating layer, by joining the solder layer and the second conductive ball by a reflow heating.

In an embodiment of the present invention, first, the substrate (the wiring substrate, the element built-in silicon wafer, or the like) that is equipped with the connection pads and the protection insulating layer (solder resist) in which the opening portions are provided on the connection pads on the surface layer side is prepared. Then, the first conductive ball (the solder ball, or the like) is arranged on the connection pads in the opening portions of the protection insulating layer respectively. Then, the solder layer is filled in the opening portions in the protection insulating layer by applying the reflow heating to the first conductive balls. Thus, a level difference of the opening portions in protection insulating layer is eliminated by the solder layer.

Then, the second conductive ball (the solder ball or other metal ball) is arranged on the solder layers respectively, and then the solder layers and the second conductive balls are joined together by applying the reflow heating. Thus, the conductive bumps projecting from the upper surface of the protection insulating layer are formed.

In this manner, in an embodiment of the present invention, the solder layer formed of the first conductive ball is buried in the opening portions in the protection insulating layer, and then the conductive bumps are formed by stacking the second conductive ball thereon respectively. As a result, even when a pitch between the connection pads is narrowed smaller than 100 µm, the conductive bumps projecting from the upper surface of the protection insulating layer at a desired height can be formed in a situation that a short circuit between adjacent solder bumps can be prevented.

Also, the solder layer which is buried in the opening portions in the protection insulating layer is formed of the solder ball. Therefore, there is no fear that voids should be produced in applying the reflow heating unlike the case where the solder paste is buried, and thus the conductive bumps can be obtained with high reliability.

In one embodiment of the present invention, the conductive ball is passed through the opening portions in the mask in which the opening portions are provided to correspond to the connection pads, and is arranged on the connection pads respectively.

Also, in an embodiment of the present invention, the first and second conductive balls are arranged via the flux. In this embodiment, in the step of forming the solder layer, the solder layer is formed to have a projection portion that projects from an upper surface of the protection insulating layer, and the flux may be transferred/formed onto the projection portions of the solder layers by pushing the projection portions of the solder layers against the flux provided on a supporting substrate.

Also, in the step of arranging the second conductive ball, the fluxes provided on the projection portions of the solder layers may be pushed against the second conductive balls arranged side by side in the ball aligning jig and adhered thereto.

As described above, in an embodiment of the present invention, even when a pitch between connection pads on the wiring substrate, or the like is narrowed, the conductive bumps of enough height can be formed on the connection pads in the opening portions in the protection insulating layer with good reliability.

### BRIEF DESCRIPTION OF THE DRAWINGS

FIGS.1A to 1C are sectional views showing a method of forming solder bumps in the prior art;
FIG.2 is a sectional view (#1) showing a method of forming conductive bumps of a first embodiment of the present invention;
FIG.3 is a sectional view (#2) showing the method of forming the conductive bumps of the first embodiment of the present invention;
FIG.4 is a sectional view (#3) showing the method of forming the conductive bumps of the first embodiment of the present invention;
FIGS.5A to 5C are sectional views (#4) showing the method of forming the conductive bumps of the first embodiment of the present invention;
FIGS.6A to 6C are sectional views (#5) showing the method of forming the conductive bumps of the first embodiment of the present invention;
FIG.7 is a sectional view showing a state in which a semiconductor chip is flip-chip mounted on the conductive bumps of a wiring substrate according to the first embodiment of the present invention;
FIG.8 is a sectional view showing a semiconductor device constructed by flip-chip mounting the semiconductor chip on the conductive bumps of the wiring substrate according to the first embodiment of the present invention;
FIGS.9A and 9B are sectional views showing a mode in which the method of forming the conductive bumps of the first embodiment of the present invention is applied in forming the conductive bumps of an element built-in silicon wafer;
FIGS.10A to 10C are sectional views (#1) showing a method of forming conductive bumps of a second embodiment of the present invention;
FIGS.11A and 11B are sectional views (#2) showing the method of forming the conductive bumps of the second embodiment of the present invention;
FIGS.12A and 12B are sectional views (#3) showing the method of forming the conductive bumps of the second embodiment of the present invention;
FIGS.13A and 13B are sectional views (#4) showing the method of forming the conductive bumps of the second embodiment of the present invention; and
FIG.14 is a sectional view showing another ball aligning jig used in the second embodiment of the present invention.

### DETALED DESCRIPTION OF THE PREFERRED EMBODIMENTS

Embodiments of the present invention will be explained with reference to the accompanying drawings hereinafter.

### (First Embodiment)

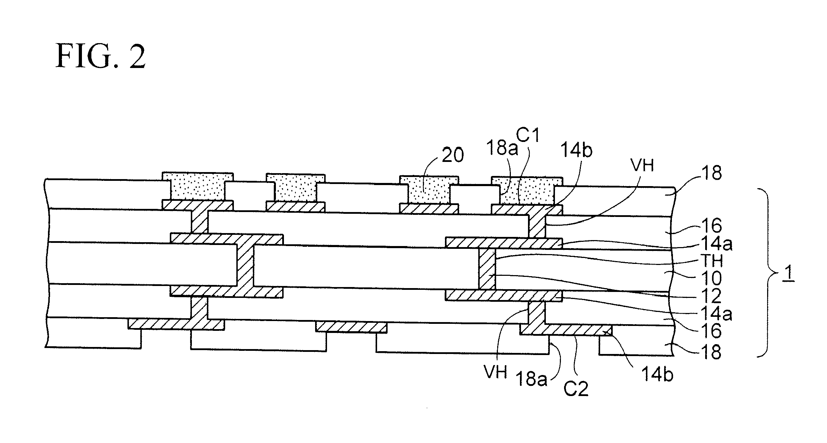

FIG.2 to FIG.6 are sectional views showing a method of forming conductive bumps of a first embodiment of the present invention.

In the method of forming the conductive bumps of the first embodiment of the present invention, as shown in FIG.2, first, a wiring substrate 1 on which the conductive bumps are to be formed is prepared. In the wiring substrate 1, through holes TH are provided in a core substrate 10 made of a glass epoxy resin, or the like, and a through electrode 12 made of copper, or the like is filled in the through holes TH respectively. Also, first wiring layers 14a made of copper, or the like and connected mutually via the through electrode 12 are formed on both surface sides of the core substrate 10 respectively.

Alternately, the first wiring layers 14a on both surface sides of the core substrate 10 may be connected mutually via the through hole plating layer formed on inner walls of the through holes TH, and a resin may be filled in the hollows in the through holes TH.

An interlayer insulating layer 16 for coating the first wiring layers 14a is formed on both surface sides of the core substrate 10 respectively. The interlayer insulating layer 16 is formed by pasting a resin film made of an epoxy resin, a polyimide resin, or the like on the core substrate 10, for example. Via holes VH whose depth arrives at the first wiring layer 14a are formed on the interlayer insulating layer 16 on both surface sides of the core substrate 10 respectively. Also, a second wiring layer 14b connected to the first wiring layer 14a via the via holes VH is formed on the interlayer insulating layer 16 on both surface sides of the core substrate 10 respectively.

Also, a solder resist 18 in which opening portions 18a are provided on connection pads C1, C2 of the second wiring layer 14b is formed on both surface sides of the core substrate 10 respectively.

In this manner, the wiring substrate 1 having the connection pads C1 and the solder resist 18 (protection insulating layer), in which the opening portion 18a is provided on the connection pads C1 respectively, on the surface side is prepared. Then, a first flux 20 is formed on the connection pads C1 of the second wiring layer 14b on the upper surface side of the wiring substrate 1. The first flux 20 is coated on the connection pads C1 in a pattern by the printing, the dispensing, the ink jet method, or the like. Otherwise, the flux may be formed on the overall upper surface side of the core substrate 10.

Here, a rigid substrate is illustrated as the wiring substrate 1. But a flexible wiring substrate using a film as a substrate may be employed.

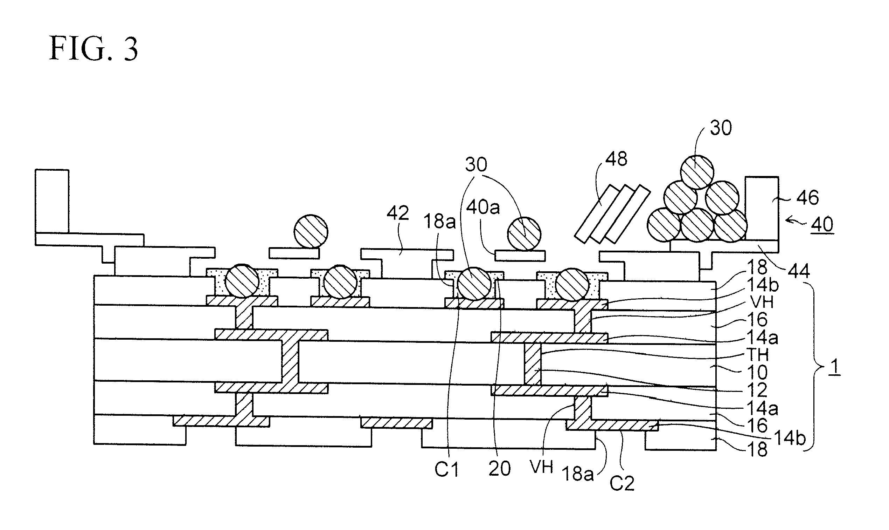

Next, a method of mounting conductive balls on the connection pads C1 on the upper surface side of such wiring substrate 1 will be explained hereunder. As shown in FIG.3, above wiring substrate 1 is loaded on a stage of a ball mounting apparatus, and then a mask 40 used to mount the conductive balls is arranged on the wiring substrate 1. The mask 40 is composed of a metal mask portion 42 in which opening portions 40a are provided, a mesh portion 44 provided on the peripheral side of the metal mask portion 42 and is made of a resin, or the like, and a frame portion 46 provided around the mesh portion 44.

At this time, the mask 40 is arranged to be aligned to the wiring substrate 1 by recognizing alignment marks of the wiring substrate 1 while using an image recognizing camera (not shown), such that the opening portions 40a of the mask 40 corresponds to the connection pads C1 of the wiring substrate 1.

Then, as also shown in FIG.3, first conductive balls 30 are supplied onto the mask 40 from a ball supplying means (not shown). The first conductive balls 30 are supplied in considerably larger numbers than those of the opening portions 40a of the mask 40 (corresponding to the connection pads C1 of the wiring substrate 1).

Then, as also shown in FIG.3, a large number of first conductive balls 30 are moved by a brush 48 and swept out into one end side of the mask 40 (an outside area of a production area). At this time, the first conductive balls 30 moved by the brush 48 pass through respective opening portions 40a of the mask 40, and then stick to the first flux 20 on the underlying connection pads C1 and are arranged there.

A size of the opening portion 40a of the mask 40 is set one size large than a size of the first conductive ball 30. Thus, the first conductive ball 30 can easily pass through the opening portion 40a of the mask 40. In this manner, one of the first conductive balls 30 is transferred into the each portion 40a of the mask 40 respectively, and is arranged on the underlying connection pads C1 of the wiring substrate 1 respectively.

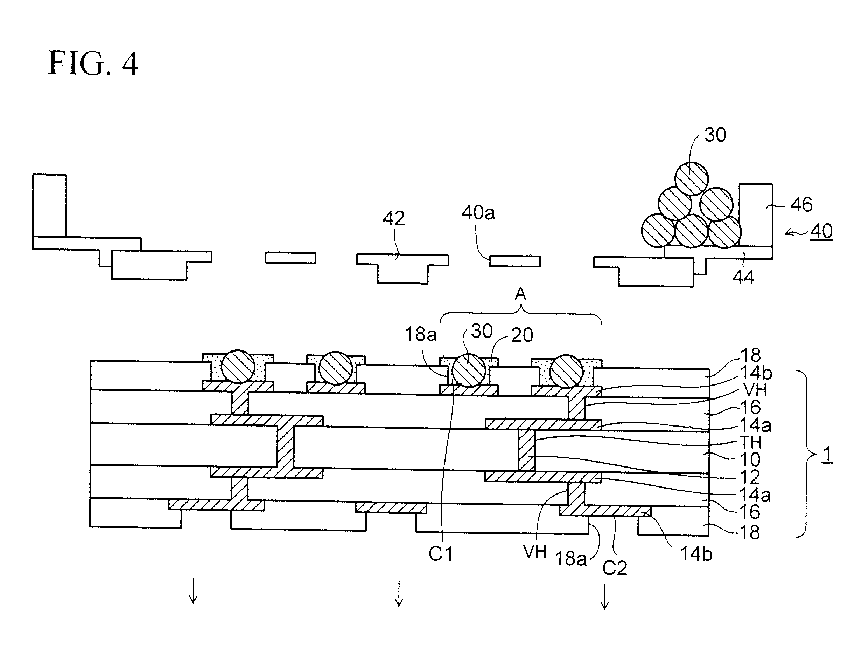

Then, as shown in FIG.4, the wiring substrate 1 is put down, and is separated from the mask 40. Then, the wiring substrate 1 is carried from the stage to the outside.

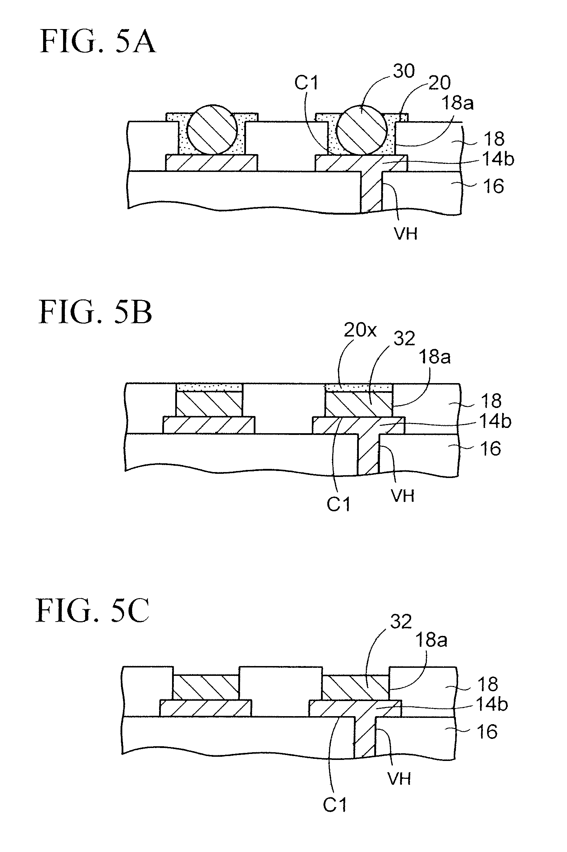

In the subsequent steps, explanation will be made while referring to fragmental enlarged sectional views in which an A portion of the wiring substrate 1 is illustrated in an enlarged manner. As shown in FIG.5A, the first conductive balls 30 are arranged on the connection pads C1 on the upper surface side of the wiring substrate 1 respectively by the ball mounting method using the mentioned-above mask 40. The first conductive balls 30 are arranged on the connection pads C1 in a state that these balls are sunk in the first flux 20 in the opening portions 18a of the solder resist 18.

As the first conductive ball 30, the solder ball made fully of solder, the ball formed by coating an outer surface of a core ball made of a resin with solder, the ball formed by coating an outer surface of a core ball made of a copper with solder, or the like may be employed. In the first conductive ball 30, the solder must be melted by the reflow heating, and therefore the ball at least an outer surface portion of which is formed of solder is employed.

The first conductive ball 30 is set in size to fill a major portion of the opening portion 18a of the solder resist 18 when the ball is melted by the reflow heating. For example, when a height of the opening portion 18a of the solder resist 18 (a film thickness of the solder resist 18 on the connection pad C1) is 20 µm and a diameter of the opening portion 18a is 50 µm, a diameter of the first conductive ball 30 is set to 40 to 45 µm.

Then, the wiring substrate 1 on which the first conductive balls 30 are mounted is reflow-heated at a temperature of 240 °C, for example. Accordingly, as shown in FIG.5B, the first conductive ball 30 is melted and thus a solder layer 32 containing the solder as a principal component is filled in the opening portion 18a of the solder resist 18 and joined to the connection pad C1. Because an oxide film of the solder is removed by a function of the first flux 20 when the first conductive ball 30 is melted, the solder layer 32 is joined to the connection pad C1 with good reliability.

At this time, as described above, the first conductive ball 30 is set in size to fill the opening portion 18a of the solder resist 18 when the ball is melted. Therefore, the main portion of the opening portion 18a of the solder resist 18 is buried by the solder layer 32. Then, as shown in FIG.5C, a flux residue 20x still remaining on the solder layer 32 in FIG.5B is removed.

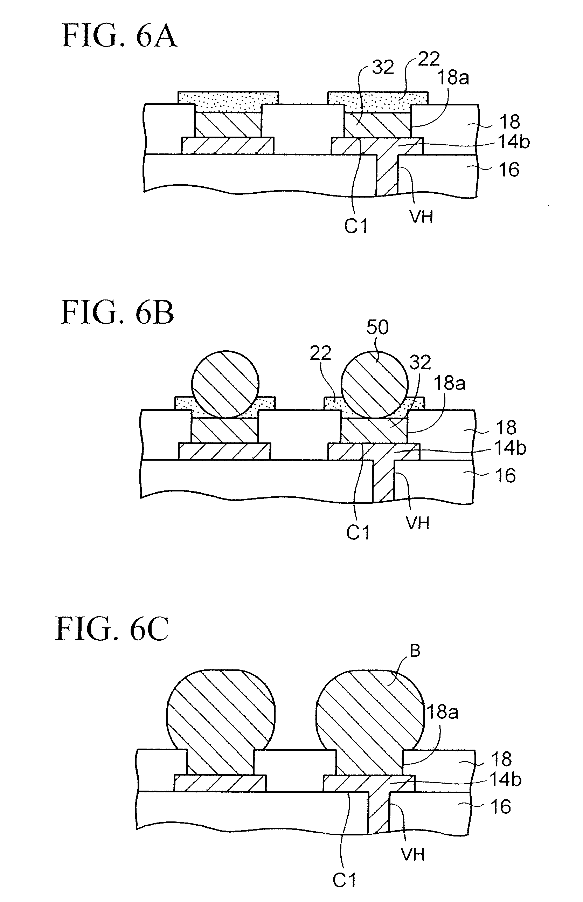

Then, as shown in FIG.6A, second fluxes 22 are formed on the solder layers 32 as patterns. The second flux 22 is formed by the similar method to the first flux 20, and may be formed on the whole surface of the wiring substrate 1 on the upper surface side. Here, when a flux which is not cured after the reflow heating is applied (low solid content flux) is employed as the above first flux 20 in FIG.2, such flux may be employed as the second flux 22 without cleaning it. In this case, the step of removing the flux residue 20x in FIG.5C and the step of forming the second flux 22 in FIG.6A are omitted.

Then, as shown in FIG.6B, a second conductive ball 50 is mounted on the second fluxes 22 on the solder layers 32 respectively. Like the foregoing method explained in FIG.3 and FIG.4, the second conductive ball 50 is arranged on the solder layers 32 through the opening portions 40a of the mask 40 respectively. As the second conductive ball 50, a metal ball such as a single-body copper ball not containing the solder, or the like may be employed in addition to the ball at least an outer surface portion of which is formed of the solder, like the first conductive ball 30.

Then, the reflow heating is applied to the wiring substrate 1 on which the second conductive balls 50 are provided. Thus, as shown in FIG.6C, the second conductive balls 50 (the solder balls, or the like) and the underlying solder layers 23 are melted, so that the second conductive balls 50 are joined to the solder layers 23 to constitute conductive bumps B. In this case, when the metal ball not containing the solder is employed as the second conductive ball 50, the underlying solder layers 23 are melted and thus the solder layer 32 are joined to the metal balls to constitute conductive bumps B.

In the present embodiment, a height of the conductive bump B from the upper surface of the solder resist 18 is mainly decided by the second conductive ball 50. The conductive bump B having a desired height can be obtained by adjusting a diameter of the second conductive ball 50.

For example, when the opening portion 18a of the solder resist 18 is mainly buried by the solder layer 32 and then the solder bump B projecting from the upper surface of the solder resist 18 at a height of 30 µm is obtained, the solder ball whose diameter is about 40 µm is employed as the second conductive ball 50. When the solder ball is employed as the second conductive ball 50, the conductive bump B whose height is slightly lower than a height of the second conductive ball 50 is formed because the solder is melted.

As described above, in the method forming the conductive bumps of the present embodiment, first, the first conductive ball 30 (the ball at least an outer surface portion of which is made of solder) is mounted on the connection pads C1 in the opening portions 18a of the solder resist 18 respectively, and then the solder layer 32 is buried in the opening portions 18a of the solder resist 18 by applying the reflow heating. Accordingly, a level difference of the opening portions 18a of the solder resist 18 is eliminated.

Then, the second conductive ball 50 (the solder ball, or the like) is mounted on the solder layers 32 respectively, and then the solder layers 32 and the second conductive balls 50 are melted by applying the reflow heating and joined together. Thus, the conductive bumps B joined to the connection pads C1 respectively and projecting from the upper surface of the solder resist 18 at a desired height are obtained.

In this manner, in the present embodiment, the solder layer 32 formed of the solder ball, or the like is buried in the opening portions 18a of the solder resist 18 on the connection pads C1 respectively to planarize the surface, and then the second conductive ball 50 is stacked separately on the solder layers 32 respectively, whereby the conductive bumps B are obtained.

According to employment of such approach, even when a pitch between the connection pads C1 is narrowed smaller than 100 µm (line : space=50 : 50 µm), the conductive bumps B projecting from the upper surface of the solder resist 18 at a desired height can be formed in a situation that a short circuit between adjacent solder bumps in the lateral direction can be prevented.

In addition, even when a film thickness of the solder resist 18 is increased (for example, 30 to 50 µm), the conductive bumps B having a desired height can be formed independent on the film thickness of the solder resist 18 since the opening portions 18a of the solder resist 18 are buried by the solder layer 32.

Also, the solder layer 32 buried in the opening portions 18a of the solder resist 18 is formed of the solder ball. Therefore, there is no fear that voids should be produced in applying the reflow heating unlike the case where the solder paste is buried, and thus the conductive bumps B with high reliability can be obtained.

In this case, a height of the conductive bumps B can be further increased by stacking a conductive ball on the conductive bumps B via the flux respectively.

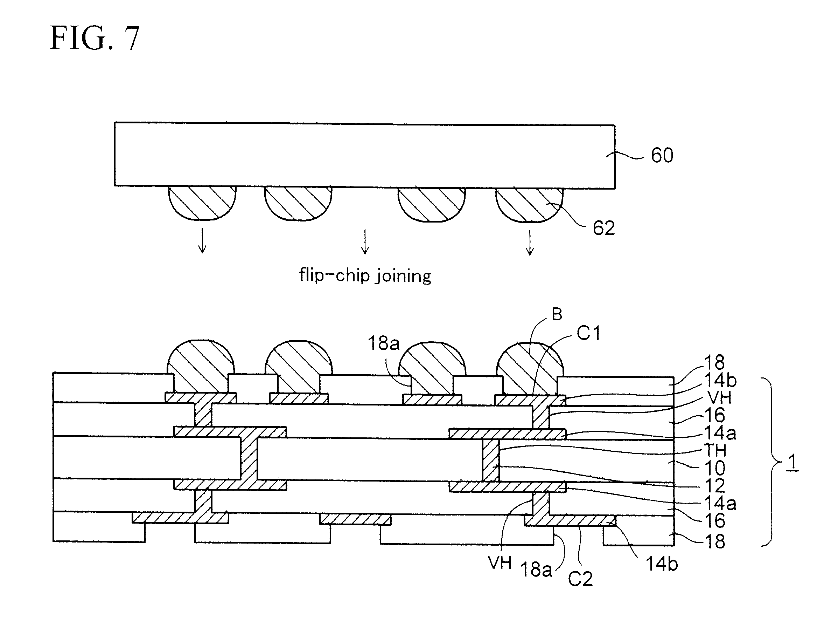

Next, a method of flip-chip connecting the semiconductor chip to the wiring substrate equipped with the conductive bumps obtained by the present embodiment will be explained hereunder. As shown in FIG.7, a semiconductor chip 60 having bumps 62 (solder) thereon is prepared, the bumps 62 of the semiconductor chip 60 are arranged to the conductive bumps B (solder) of the wiring substrate 1, and the bumps 62 are flip-chip joined to the conductive bumps B by the reflow heating.

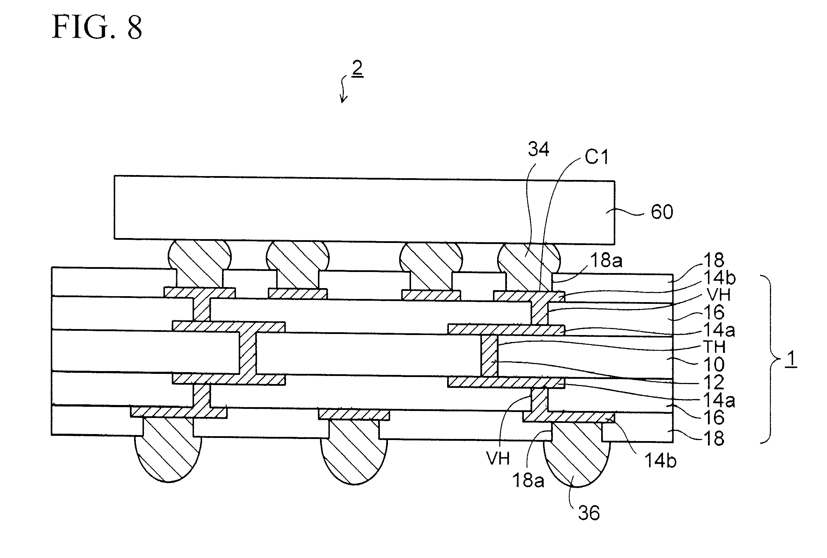

Accordingly, as shown in FIG.8, the conductive bumps B of the wiring substrate 1 and the bumps 62 of the semiconductor chip 60 are fused together and then bump electrodes 34 are formed. Thus, the semiconductor chip 60 is connected electrically to the connection pads C1 of the semiconductor substrate 1 by the bump electrodes 34.

The bumps 62 of the semiconductor chip 60 and the conductive bumps B of the wiring substrate 1 can be formed of not only the solder but also various metals.

Then, before or after the mounting of the semiconductor chip 60, external connection terminals 36 are provided by mounting the solder ball on the connection pads C2 on the lower surface side of the wiring substrate 1, or the like.

Accordingly, a semiconductor device 2 according to the present embodiment is obtained. In this case, when the large-size substrate for multiple production is used as the wiring substrate 1, the wiring substrate 1 is cut and divided before or after the semiconductor chip 60 is the mounted.

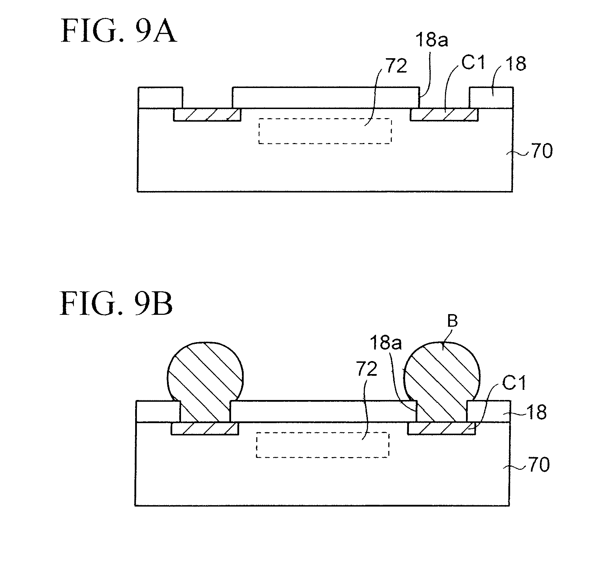

In the present embodiment, the method of forming the conductive bumps on the wiring substrate onto which the semiconductor chip is to be flip-chip mounted is illustrated. But the conductive bumps may be formed on the element built-in silicon wafer instead of the wiring substrate. Such element built-in silicon wafer 70 is shown in FIG.9A. As shown in FIG.9A, an element area 72, in which an semiconductor element such as a transistor, a diode, or the like is built, is provided in the element built-in silicon wafer 70. Also, a multi-layered wiring (not shown) which wires the transistors, or the like is formed over the element area 72.

Also, the connections pads C1 connected to the multi- layered wiring are provided on the upper surface side of the element built-in silicon wafer 70. Also, the protection insulating layer 18 (passivation layer) in which the opening portions 18a are provided on the connections pads C1 is formed. A plurality of chip areas are built in the element built-in silicon wafer 70, but one chip area in the wafer is shown schematically in FIG.9A.

Then, as shown in FIG.9B, according to the similar method to the above method of forming the conductive bumps, the conductive bumps B which are connected to the connections pads C1 of the element built-in silicon wafer 70 and projected from the upper surface of the protection insulating layer 18 at a desired height are formed.

Such element built-in silicon wafer 70 is divided into individual semiconductor chips such as CPUs, memories, etc. by the dicing.

### (Second Embodiment)

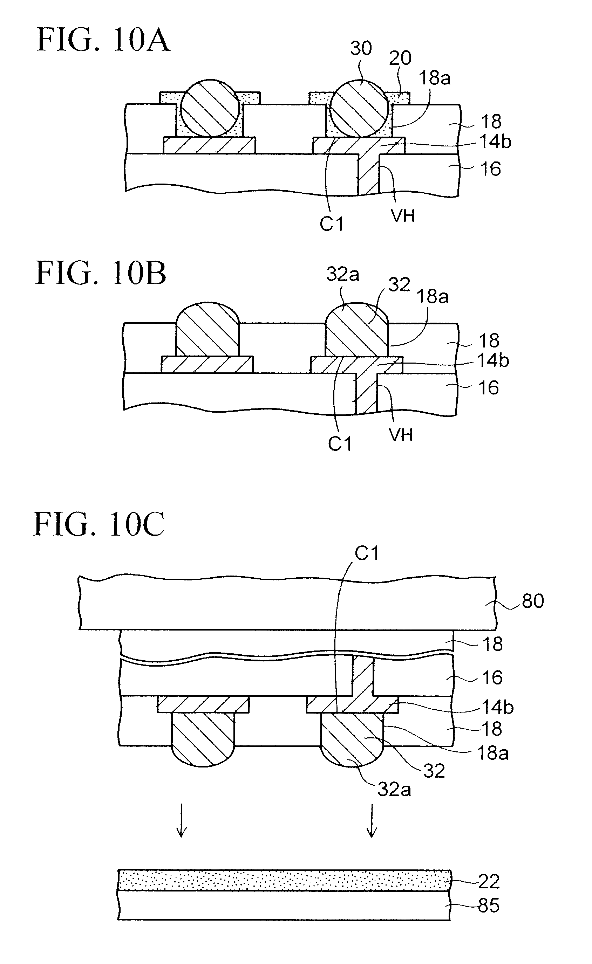

FIG.10 to FIG.13 are sectional views showing a method of forming conductive bumps of a second embodiment of the present invention. A difference of the second embodiment from the first embodiment resides in the method of forming the second flux and the method of mounting the second conductive balls. In the second embodiment, detailed explanation about the same steps as those in the first embodiment will be omitted herein.

First, as shown in FIG.10A, like the first embodiment, the first conductive ball 30 is arranged on the first flux 20 on the connection pads C1 in the opening portions 18a of the solder resist 18 respectively. In the second embodiment, a diameter of the first conductive ball 30 is set larger than that of the first embodiment such that the solder layer is protruded from the upper surface of the solder resist 18 after the reflow heating. For example, when a height of the opening portion 18a of the solder resist 18 is 20 µm and a diameter of the same is 50 µm, the first conductive ball 30 whose diameter is slightly smaller than 50 µm is placed. Thus, the first conductive ball 30 is caused to project from the upper surface of the solder resist 18 by about 30 µm.

Then, as shown in FIG.10B, the first conductive ball 30 is melted by applying the reflow heating. Thus, the solder layer 32 is buried in the opening portion 18a of the solder resist 18, and also is joined to the connection pad C1. At this time, a height of the first conductive ball 30 is lowered because it is melted, and the solder layer 32 is formed to have a projection portion 32a that is projected from the upper surface of the solder resist 18 by about 20 µm.

In this manner, in the second embodiment, the second flux is formed on the top end portions of the solder layers 32 as described later. Therefore, the projection portions 32a of the solder layers 32 are caused to project from the upper surface of the solder resist 18.

Then, as shown in FIG.10C, an adsorbing jig 80 is caused to adsorb the solder resist 18 on the back surface of the wiring substrate 1, and thus the wiring substrate 1 is supported by the adsorbing jig 80. The adsorbing jig 80 has an adsorbing port (not shown), and the adsorbing jig 80 can adsorb and support the wiring substrate 1 by evacuating an air through the adsorbing port.

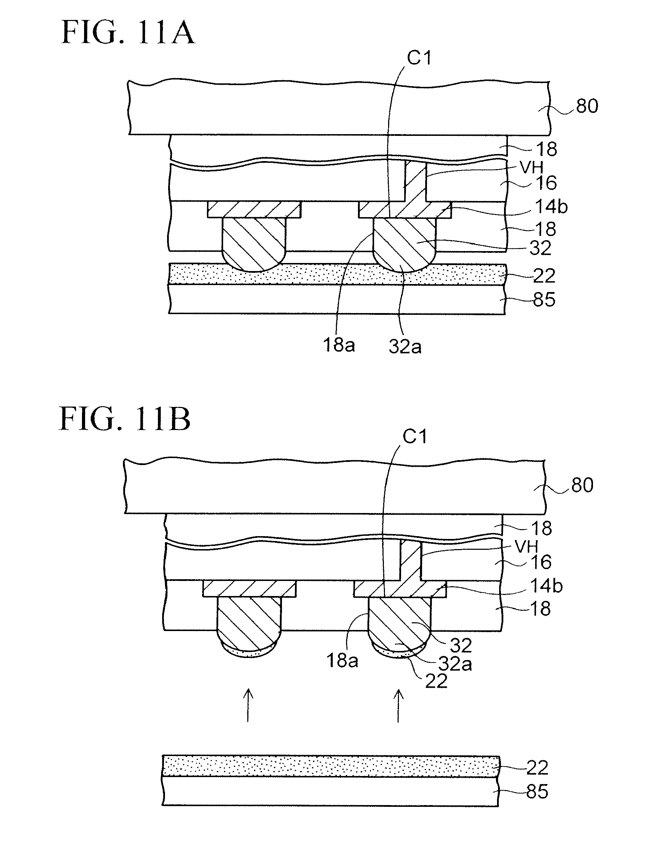

Then, as also shown in FIG.10C, a supporting substrate 85 on a surface of which the viscous second flux 22 is coated is prepared. Then, as shown in FIG.10C and FIG.11A, the projection portions 32a of the solder layers 32 on the wiring substrate 1 which is supported by the adsorbing jig 80 are pushed against the second flux 22 on the supporting substrate 85.

Then, as shown in FIG.11B, the wiring substrate 1 which is supported by the adsorbing jig 80 is pulled up from the second flux 22. Thus, the second flux 22 is transferred/formed onto the top ends of the projection portions 32a of the solder layers 32 on the wiring substrate 1. In this manner, since the transferring technology is utilized in the second embodiment, the second flux 22 can be coated selectively and collectively in a self-alignment fashion onto the projection portions 32a of the solder layers 32 without use of a mask.

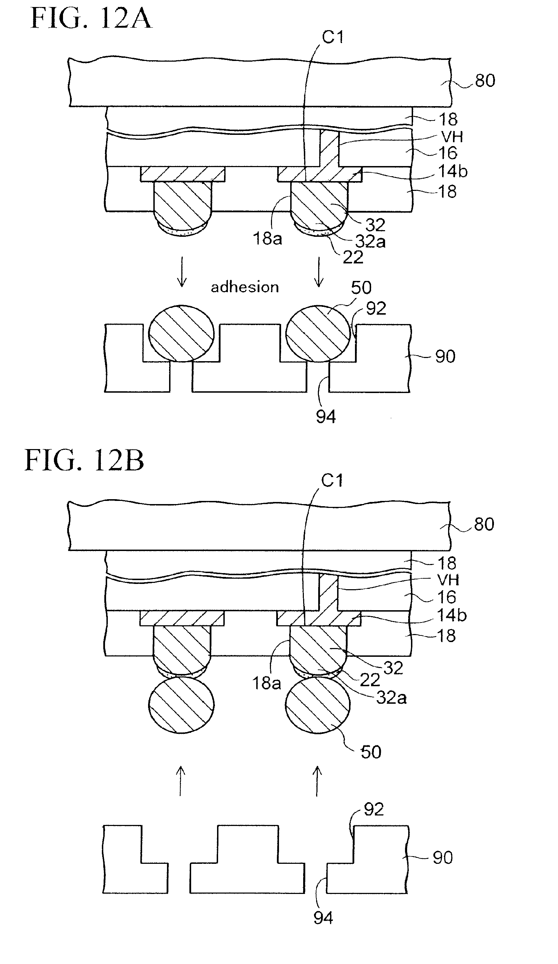

Then, as shown in FIG.12A, a ball aligning jig 90 used to align a plurality of balls is prepared. A plurality of recess portions 92 are provided on the upper surface side of the ball aligning jig 90, and an alignment port 94 used to align the ball is opened in centers of bottom portions of the recess portions 92 respectively. Then, the second conductive ball 50 is arranged on the alignment ports 94 in the recess portions 92 of the ball aligning jig 90 respectively. The alignment ports 94 in the recess portions 92 of the ball aligning jig 90 are aligned to correspond to the connection pads C1 of the wiring substrate 1.

Then, as also shown in FIG.12A, the second fluxes 22 which are transferred onto the projection portions 32a of the solder layers 32 on the wiring substrate 1, which is supported by the adsorbing jig 80, are aligned to oppose to the second conductive balls 50 which are aligned on the ball aligning jig 90. Then, the second fluxes 22 on the solder layers 32 are pushed against the second conductive balls 50, and are adhered collectively thereto.

Then, as shown in FIG.12B, the wiring substrate 1 which is supported by the adsorbing jig 80 is pulled up upward. Thus, the second conductive balls 50 are collectively transferred/formed onto the second fluxes 22 on the solder layers 32 on the wiring substrate 1 from the ball aligning jig 90 side.

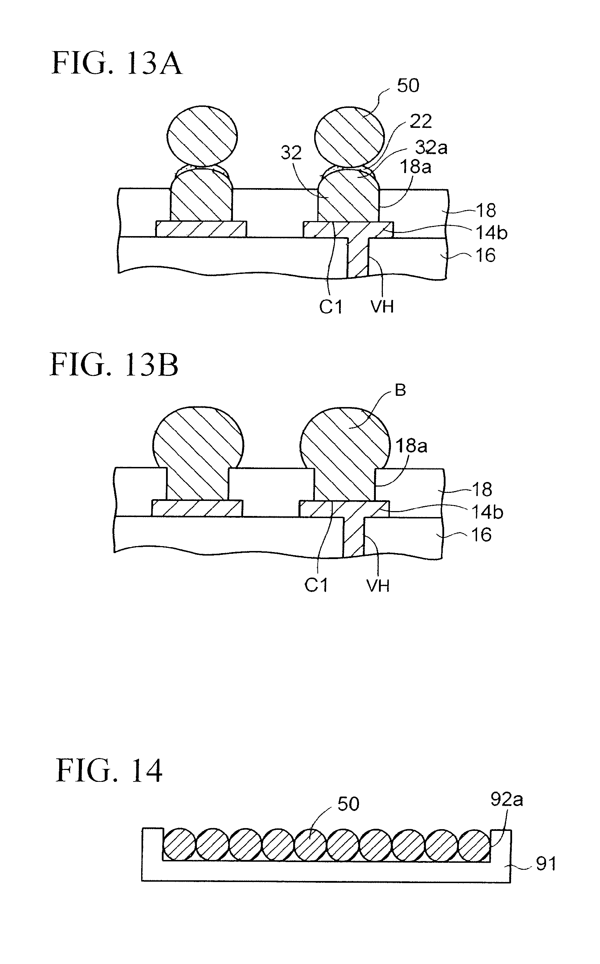

In this manner, as shown in FIG.13A, like the first embodiment, the second conductive ball 50 is stacked on the solder layers 32 on the connection pads C1 of the wiring substrate 1 via the second flux 22 respectively.

In this case, as shown in FIG.14, instead of the ball aligning jig 90 in which a plurality of recess portions 92 are arranged in FIG.12A, while using a plate-like ball aligning jig 91 having a collective recess portion 92a in the inside, a large number of conductive balls may be spread all over in the lateral direction and be arranged in the recess portion 92a. In this case, like FIG.12B, the second conductive balls 50 can also be adhered collectively onto the second fluxes 22 provided to the projection portions 32a of the solder layers 32 on the wiring substrate 1 individually.

Then, the reflow heating is applied to the structure in FIG.13A, and then the flux residue is removed. As a result, as shown in FIG.13B, the solder layers 32 and the second conductive balls 50 are melted mutually and thus the conductive bumps B projected from the upper surface of the solder resist 18 at a desired height can be obtained.

The second embodiment can achieve the similar advantages to those in the first embodiment. In addition to this, in the second embodiment, the second fluxes 22 and the second conductive balls 50 are formed collectively by the transfer method. Therefore, particularly when a pitch between the connection pads C1 is narrowed, the conductive bumps B can be formed with good reliability at a higher production efficiency than that in the first embodiment.

## Claims

1. A method of forming a conductive bump, comprising the steps of:
preparing a substrate (1) including a connection pad (C1) and a protection insulating layer (18), in which an opening portion (18a) is provided on the connection pad (C1), on a surface layer side;
arranging a first conductive ball (30), at least an outer surface portion of which is made of solder, on the connection pad (C1) in the opening portion (18a) of the protection insulating layer (18);
filling a solder layer (32) in the opening portion (18a) by applying a reflow heating to the first conductive ball(30);
arranging a second conductive ball (50) on the solder layer (32); and
obtaining conductive bump (B) which protrudes from an upper surface of the protection insulating layer (18), by joining the solder layer (32) and the second conductive ball (50) by a reflow heating.

2. A method of forming a conductive bump, according to claim 1, wherein at least an outer surface portion of the second conductive ball (50) is made of solder.

3. A method of forming a conductive bump, according to claim 1 or 2, wherein, in the respective step of arranging the first conductive ball (30) and the second conductive ball (50), the conductive ball (30, 50) passes through a opening portion (40a) of a mask (40) which has the opening portion (40a) corresponding to the connection pad (C1), and is arranged.

4. A method of forming a conductive bump, according to claim 1, 2 or 3, wherein, in the step of arranging the first conductive ball (30), the first conductive ball (30) is arranged on the connection pad (C1) via a flux (20), and
in the step of arranging the second conductive ball (50), the second conductive ball (50) is arranged on the solder layer (32) via a flux (22).

5. A method of forming a conductive bump, according to claim 4, wherein, in the step of forming the solder layer (32), the solder layer (32) is formed to have a projection portion (32a) which projects from an upper surface of the protection insulating layer (18), and
the flux (22) is transferred/formed onto the projection portion (32a) of the solder layer (32) by pushing the projection portion (32a) of the solder layer (32) against the flux (22) provided on a supporting substrate (85).

6. A method of forming a conductive bump, according to claim 5, wherein, in the step of arranging the second conductive ball (50), the flux (22) provided on the projection portion (32a) of the solder layer (32) is pushed against the second conductive ball (50) arranged side by side in a ball aligning jig (90) and adhered thereto, whereby the second conductive ball (50) is transferred/formed on the solder layer (32).

7. A method of forming a conductive bump, according to any preceding claim, wherein the substrate (1) is a wiring substrate to the conductive bump (B) of which a semiconductor chip is flip-chip connected, or an element built-in silicon wafer (70) in which a semiconductor element is built.
